(19) Europäisches Patentamt / European Patent Office / Office européen des brevets

(11) **EP 3 087 678 B1**

(12) **FASCICULE DE BREVET EUROPEEN**

(45) Date de publication et mention
de la délivrance du brevet:
**04.10.2017 Bulletin 2017/40**

(21) Numéro de dépôt: **14831014.7**

(22) Date de dépôt: **23.12.2014**

(51) Int Cl.:
*H03M 13/33* (2006.01)      *H03M 13/09* (2006.01)
*H03M 13/45* (2006.01)      *H04L 1/00* (2006.01)
*G06F 11/10* (2006.01)

(86) Numéro de dépôt international:
**PCT/FR2014/053532**

(87) Numéro de publication internationale:
**WO 2015/097404 (02.07.2015 Gazette 2015/26)**

(54) **CORRECTION D'ERREURS AVEC TEST DE PLUSIEURS LONGUEURS POUR UNE TRAME DE DONNÉES**

FEHLERKORREKTUR MIT TEST MEHRERER LÄNGEN FÜR EINEN DATENRAHMEN

ERROR CORRECTION WITH TEST OF A PLURALITY OF LENGTHS FOR A DATA FRAME

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **26.12.2013 FR 1363578**

(43) Date de publication de la demande:
**02.11.2016 Bulletin 2016/44**

(73) Titulaires:
• **GRDF
75009 Paris (FR)**
• **SUEZ Groupe
92040 Paris la Défense Cedex (FR)**

(72) Inventeur: **DORNSTETTER, Jean Louis
F-78460 Choisel (FR)**

(74) Mandataire: **Gendron, Vincent Christian et al
Fédit-Loriot
38, avenue Hoche
75008 Paris (FR)**

(56) Documents cités:
**EP-A1- 1 819 058      US-A- 6 061 823
US-B1- 7 609 724**

• **UEDA H ET AL: "A METHOD OF IMPROVING
MISFRAME FOR HEC-BASED VARIABLE
LENGTH FRAME SUITABLE FOR IP SERVICES",
ELECTRONICS & COMMUNICATIONS IN JAPAN,
PART I - COMMUNICATIONS, WILEY, HOBOKEN,
NJ, US, vol. 86, no. 6, PART 01, janvier 2003
(2003-01), pages 46-58, XP001142971, ISSN:
8756-6621, DOI: 10.1002/ECJA.10018**

EP 3 087 678 B1

## Description

La présente invention se rapporte à un procédé de réception de données numériques dans lequel les données sont transmises par trames en utilisant un codage de contrôle d'intégrité d'une trame transmise, notamment mais non exclusivement un codage de contrôle par redondance cyclique.

L'invention trouve une application dans tous les cas où un signal numérique est transmis ou diffusé sur des canaux bruités. A titre d'exemple, la présente invention peut être mise en oeuvre dans les récepteurs déployés dans les installations de télérelève. Une installation de télérelève comprend classiquement plusieurs dispositifs de comptage, par exemple des compteurs d'eau, de gaz, d'électricité ou plus généralement de fluide ou d'énergie, ainsi que des systèmes de passerelle communiquant d'une part avec les dispositifs de comptage et d'autre part avec un réseau de télécommunications externe.

Les dispositifs de comptage transmettent vers un ou plusieurs systèmes de passerelle de l'installation des données de comptage, par exemple des données de consommation d'eau. Chaque système de passerelle transmet les données de comptage vers le réseau de télécommunications. Les données ainsi collectées peuvent ensuite être analysées, par exemple afin de détecter les fuites éventuelles ou autres défaillances, et également à des fins de facturation client.

Les dispositifs de comptage comprennent un module de comptage de données de consommation de fluide ou d'énergie et un module radiofréquence pour communiquer avec le ou les systèmes de passerelle voisin(s). Ce module radiofréquence peut par exemple émettre des ondes de relativement courte portée, par exemple à 169 MHz, ou bien encore à 433 MHz ou 868 MHz.

Un système de passerelle comprend un dispositif concentrateur, ou armoire de collecte, installé par exemple dans un local technique d'immeuble, et un (ou plusieurs) dispositif d'émission/réception radiofréquence, installé par exemple sur le toit de l'immeuble, pour communiquer avec les modules radiofréquences des dispositifs de comptage.

Une installation de télérelève fait ainsi appel à des techniques de transmission numériques bien connues et faisant l'objet de standards publiés par exemple par l'ETSI (European Télécommunications Standards Institute, en anglais).

Da manière générale, un système de transmission numérique véhicule de l'information en utilisant un support physique comme le câble, la fibre optique ou la propagation sur un canal radioélectrique. On désignera un tel support physique par le terme canal. Classiquement, un tel système exige une vérification de l'intégrité des trames reçues et comprend pour ce faire, au niveau de l'émission, un codage de contrôle d'intégrité, par exemple au moyen de bits de contrôle de redondance cyclique, permettant de détecter les erreurs de transmission de trame. La fonction de codage de contrôle d'intégrité consiste pour le dispositif émetteur lors d'une transmission de données, à exécuter un calcul pour créer les bits de contrôle, joints aux données transmises, qui, lors du décodage au niveau de la réception, vont permettre au récepteur, à partir de l'information arrivant à destination, éventuellement entachée par les perturbations intervenant sur le canal, notamment de type bruit, atténuations et interférences, et après avoir effectué le même calcul, de vérifier l'intégrité de la trame reçue et ainsi déterminer si la transmission peut être considérée comme correcte ou non.

Dans une installation de télérelève telle que mentionnée ci-dessus permettant de collecter des données de consommation de fluide ou d'énergie, chacun des compteurs procède à la transmission à intervalles plus ou moins réguliers des données organisées en trames, typiquement de taille de l'ordre de quelques dizaines d'octets. Le facteur de mérite principal d'un récepteur côté système de passerelle dans une telle installation réside dans sa capacité à pouvoir identifier correctement chacune des trames émises par les différents compteurs qui auront été assignés à un canal de réception donné. Or, la très grande variabilité des conditions de propagation entre les compteurs et le récepteur côté passerelle conduit à une distribution très large de l'énergie effectivement collectée en provenance de l'émetteur d'une trame. Aussi, en raison de la présence inévitable de bruit additif, la performance du récepteur se mesure par sa capacité à recevoir des trames en présence de bruit additif large bande, typiquement caractérisée pour une longueur de trame donnée en termes de taux d'erreurs binaires pour un rapport signal à bruit donné, lequel dépend de façon cruciale du niveau d'énergie par bit d'information effectivement collecté dont il est fait mention ci-dessus.

Un récepteur procède classiquement au décodage du code correcteur d'erreurs appliqué en transmission. Lorsque les conditions de transmission sont mauvaises, c'est-à-dire pour des conditions de transmission de faible rapport signal à bruit, il arrive que le procédé de décodage ne puisse pas corriger toutes les erreurs affectant la trame reçue. Selon la terminologie usuelle, on comptabilise sous le nom d'erreurs de première espèce les évènements correspondant aux cas où une trame effectivement transmise n'est pas décodée correctement par le récepteur. Dans l'optique de concevoir un récepteur performant, il convient bien entendu de chercher à minimiser le taux moyen d'erreurs de première espèce (lequel est facile à définir ainsi qu'à mesurer de façon non ambigüe pour un scénario de perturbations du canal de transmission donné, tel que la présence d'un bruit blanc additif), dans la mesure où le décodage d'une trame erronée aura alors grevé inutilement les ressources du récepteur, tant en termes d'énergie consommée qu'en temps de latence.

Cependant, il s'avère que cet objectif visant à minimiser le taux moyen d'erreurs de première espèce conduit à la mise en oeuvre de moyens qui tendent à augmenter la fréquence moyenne des erreurs dites de seconde espèce, relatives aux évènements correspondant aux cas où le récepteur est conduit à « inventer » une trame prétendument correctement reçue alors qu'en réalité aucun signal autre que des perturbations du canal issues des fluctuations erratiques dues au bruit ainsi qu'aux divers signaux parasites n'est présent. Ces erreurs de seconde espèce n'ayant par nature pas de rapport direct avec l'émission de trames, il est d'usage de les quantifier sous forme d'un temps moyen entre évènements successifs plutôt que sous la forme d'un quelconque taux ou ratio. Quoi qu'il en soit, une telle erreur de seconde espèce, qui se traduit par le déclenchement intempestif de divers mécanismes internes au récepteur, résulte usuellement de la conjonction de deux facteurs, qui sont lié d'une part, à la décision de tenter de démoduler une trame suite à la détection de ce qui a l'apparence d'un début de trame et, d'autre part, la classification comme suffisamment plausible du contenu de ladite trame candidate compte tenu de la connaissance a priori de sa structure.

Ainsi, on pourrait envisager de minimiser les erreurs de seconde espèce en prévoyant de ne déclencher les opérations de réception de trame que lorsque la vraisemblance de la présence d'un début de trame est suffisamment élevée compte tenu du signal reçu par le récepteur. Cependant, le fait d'exiger dans ce cas une valeur plus élevée de ladite vraisemblance conduit inévitablement à augmenter la probabilité de ne pas satisfaire ces exigences de vraisemblance ainsi accrues lors du traitement de signaux représentant une trame effectivement émise quoique reçue affectée de perturbations telles que du bruit additif ou autres. Ainsi, il en résulte inéluctablement une augmentation indésirable des erreurs de première espèce, ce qui revient à dégrader la sensibilité effective du récepteur.

En pratique, il s'agit d'effectuer un compromis entre les objectifs contradictoires de minimisation des erreurs respectives de première et de seconde espèce.

On connaît des documents US 6 071 823 ou EP 1 819 058 un procédé de détection et correction d'erreurs à l'aide d'un code à redondance cyclique (CRC), comprenant une étape d'inversion de séquences de bits de faible fiabilité pour générer des séquences testées à l'aide du CRC.

On connaît également du document de Ueda H et al: "A Method of Improving Misframe for HEC-Based Variable Length Frame Suitable for IP Services", Electronics & Communications in Japan, Part 1, Wiley, vol. 86, no. 6, janvier 2003, pages 46-58, un procédé de detection et correction d'erreurs utilisant un CRC, ce dernier étant également utilisé pour tester plusieurs longueurs de trame.

Aussi, un problème qui se pose et que vise à résoudre la présente invention, est de proposer un procédé de réception de données numérique, en particulier dans une installation de télérelève, permettant d'obtenir une correction d'erreurs très performante, tout en augmentant la sensibilité du récepteur.

Dans le but de résoudre ce problème, la présente invention propose un procédé de réception de données numériques transmises par trames utilisant un codage de contrôle d'intégrité par lequel, avant une étape de transmission d'une trame sur un canal, on adjoint à la trame une information supplémentaire de validation de trame créée à l'aide dudit codage de contrôle d'intégrité et, après ladite étape de transmission sur ledit canal, on procède à une estimation de la trame reçue au moyen d'une unité de décodage permettant de déterminer une trame de référence par décisions fermes relativement à la valeur de chaque bit reçu d'une suite de bits de longueur N considérée et on procède à une vérification de la compatibilité de ladite trame de référence fournie par les décisions fermes avec ledit codage de contrôle d'intégrité utilisé, ledit procédé étant caractérisé en ce qu'il comprend des étapes consistant, pour chaque trame reçue :

- à calculer, pour chaque bit de ladite trame de référence fournie par les décisions fermes, une valeur de vraisemblance de la valeur du bit reçu représentative de la probabilité d'erreur de transmission pour les bits considérés ;

et, en cas de non-compatibilité de ladite trame de référence avec ledit codage de contrôle d'intégrité :

- à identifier dans ladite trame de référence un ensemble fini non vide de bits les plus vraisemblablement erronés en fonction desdites valeurs de vraisemblance calculées pour chaque bit ;
- à énumérer une pluralité de trames candidates correspondant chacune respectivement à l'une des combinaisons possibles de nombre d'inversions des bits les plus vraisemblablement erronés identifiés dans ladite trame de référence ;
- à vérifier la compatibilité des trames candidates de ladite pluralité de trames candidates énumérées avec ledit codage de contrôle d'intégrité ;
- à sélectionner une trame candidate compatible avec ledit codage de contrôle d'intégrité,

ledit procédé comprenant en outre des étapes consistant à recevoir un premier ensemble de bits donnant la longueur de la trame, à considérer au moins deux valeurs candidates de longueur de trame déterminées en fonction des valeurs de vraisemblance calculées pour chaque bit dudit premier ensemble de bits, et à procéder à l'estimation de la trame reçue dans l'ordre croissant des longueurs de trame considérées, successivement.

S'agissant de l'application de la présente invention au domaine de la télérelève, étant données les longueurs de trame considérées, le nombre typique de membres de l'ensemble fini non vide discuté ci-dessus est de l'ordre de quelques unités, par exemple allant de un a trois ou quatre.

Selon un mode de réalisation, le procédé comprend des étapes consistant à ordonner l'énumération de chaque trame candidate par ordre croissant de leur fiabilité et par ordre croissant du nombre d'inversions des bits les plus vraisemblablement erronés identifiés dans ladite trame de référence et à vérifier itérativement la compatibilité des trames candidates ainsi ordonnées, de sorte à arrêter les itérations dès qu'une trame candidate est vérifiée compatible avec ledit codage de contrôle d'intégrité, par quoi ladite trame candidate sélectionnée est celle de l'itération courante.

En variante, le procédé peut comprendre des étapes consistant :

- à déterminer, pour chaque trame candidate de ladite pluralité de trames candidates énumérées, un score de fiabilité résultant de la somme desdites valeurs de vraisemblance calculées pour chaque bit, pondérées en fonction de la valeur du bit correspondant dans ladite trame candidate ;
- à sélectionner la trame candidate parmi ladite pluralité de trames candidates énumérées qui maximise ledit score de fiabilité tout en étant compatible avec ledit codage de contrôle d'intégrité.

De préférence, lesdites au moins deux valeurs candidates de longueur de trame considérées comprennent une première valeur candidate de longueur de trame obtenue par décisions fermes relativement à la valeur de chaque bit reçu dudit premier ensemble de bits et une deuxième valeur candidate de longueur de trame obtenue par inversion du bit le plus vraisemblablement erroné dudit premier ensemble de bit.

Avantageusement, l'identification dans ladite trame de référence dudit ensemble fini non vide de bits les plus vraisemblablement erronés consiste à mémoriser depuis le début de réception de la trame un ensemble d'information comprenant au moins la position des bits concernés dans la trame et la valeur de vraisemblance associée et à mettre à jour ledit ensemble d'informations après réception de chaque bit supplémentaire, ladite mise à jour consistant à comparer la valeur de vraisemblance associée audit bit supplémentaire reçu avec la plus grande en valeur absolue des valeurs de vraisemblance préalablement mémorisées, et à modifier ledit ensemble d'informations, de sorte à remplacer la plus fiable des positions mémorisées par la position dudit bit supplémentaire reçu si celui-ci s'avère moins fiable.

De préférence, lesdites valeurs de vraisemblance calculées pour chaque bit reçu résultent du calcul du coefficient de vraisemblance logarithmique de la valeur du bit reçu défini par le logarithme du rapport de la probabilité conditionnelle que le bit reçu est dans un premier état compte tenu de la valeur du bit reçu à la probabilité conditionnelle que le bit reçu est dans un second état compte tenu de cette même valeur du bit reçu.

Selon un mode de réalisation, ledit codage de contrôle d'intégrité est effectué par un codage de contrôle de redondance cyclique.

En variante, ledit codage de contrôle d'intégrité est effectué par un algorithme de hachage.

De préférence, le procédé est mis en oeuvre par un dispositif d'émission/réception radiofréquence d'un système de passerelle dans une installation de télérelève comprenant en outre une pluralité de dispositifs de comptage, chaque dispositif de comptage comprenant un module de comptage et un module radiofréquence pour transmettre des données à destination dudit dispositif d'émission/réception radiofréquence dudit système de passerelle.

Il est en outre proposé un programme d'ordinateur comprenant des instructions pour effectuer les étapes du procédé selon l'invention lorsque ces instructions sont exécutées par un processeur. Ce programme d'ordinateur peut par exemple être stocké sur un support mémoire du type disque dur ou autre, ou bien encore être téléchargé, etc.

Il est en outre proposé un dispositif de réception de données numériques comprenant des moyens matériels et/ou logiciels pour la mise en oeuvre du procédé selon l'invention.

En particulier, il est proposé un dispositif de réception de données numériques transmises par trames utilisant un codage de contrôle d'intégrité, du type comprenant une unité de décodage agencée de façon à fournir en sortie des décisions fermes relativement à la valeur de chaque bit reçu d'une suite de bits de longueur N considérée, l'ensemble desdites décision fermes constituant une trame de référence correspondant à une estimation d'une trame reçue, et une unité de contrôle agencée pour calculer une information de validation de trame apte à fournir une indication de la compatibilité de la trame reçue avec ledit codage de contrôle d'intégrité utilisé, ledit dispositif étant caractérisé en ce que ladite unité de décodage comprend :

- des moyens de calculs d'une valeur de vraisemblance de la valeur du bit reçu représentative de la probabilité d'erreur de transmission pour chaque bit reçu de ladite trame de référence,
- des moyens de mémorisation d'un ensemble fini non vide de bits les plus vraisemblablement erronés de ladite trame de référence en fonction desdites valeurs de vraisemblance calculées pour chaque bit,
- des moyens de décision agencés pour énumérer une pluralité de trames candidates correspondant chacune respectivement à l'une des combinaisons possibles de nombre d'inversion des bits les plus vraisemblablement erronés, ladite unité de contrôle étant conçue pour vérifier la compatibilité des trames candidates de ladite pluralité de trames candidates énumérées avec ledit codage de contrôle d'intégrité, lesdits moyens de décision étant agencés pour sélectionner une trame candidate compatible avec ledit codage de contrôle d'intégrité afin d'estimer la trame reçue, ladite unité de décodage étant en outre adaptée pour recevoir un premier ensemble de bits donnant la longueur de la trame, considérer au moins deux valeurs candidates de longueur de trame déterminées en fonction des valeurs de vraisemblance calculées pour chaque bit dudit premier ensemble de bits, et procéder à l'estimation de la trame reçue dans l'ordre croissant des longueurs de trame considérées, successivement.

Le dispositif de réception peut comprendre un processeur, par exemple un DSP (de l'anglais « Digital Signal Processing »), un micro contrôleur, un micro processeur ou autre.

Il est en outre proposé un système de passerelle pour une installation de télérelève, ledit système de passerelle comprenant au moins un dispositif d'émission/réception radiofréquence pour communiquer avec une pluralité de dispositifs de comptage de ladite installation de télérelève, ledit dispositif d'émission/réception radiofréquence comprenant un dispositif de réception tel que décrit ci-dessus.

Il est en outre proposé un dispositif de comptage pour une installation de télérelève du type comprenant un module de comptage agencé pour mesurer des données de consommation de fluide ou d'énergie, et un module radiofréquence pour communiquer avec un dispositif d'émission/réception/radiofréquence d'un système de passerelle de ladite installation de télérelève, ledit module radiofréquence comprenant un dispositif de réception tel que décrit ci-dessus.

Il est en outre proposé une installation de télérelève comprenant plusieurs dispositifs de comptage tels que décrits ci-dessus et au moins un système de passerelle tel que décrit ci-dessus.

D'autres particularités et avantages de l'invention ressortiront à la lecture de la description faite ci-après d'un mode de réalisation particulier de l'invention, donné à titre indicatif mais non limitatif, en référence aux dessins annexés sur lesquels :

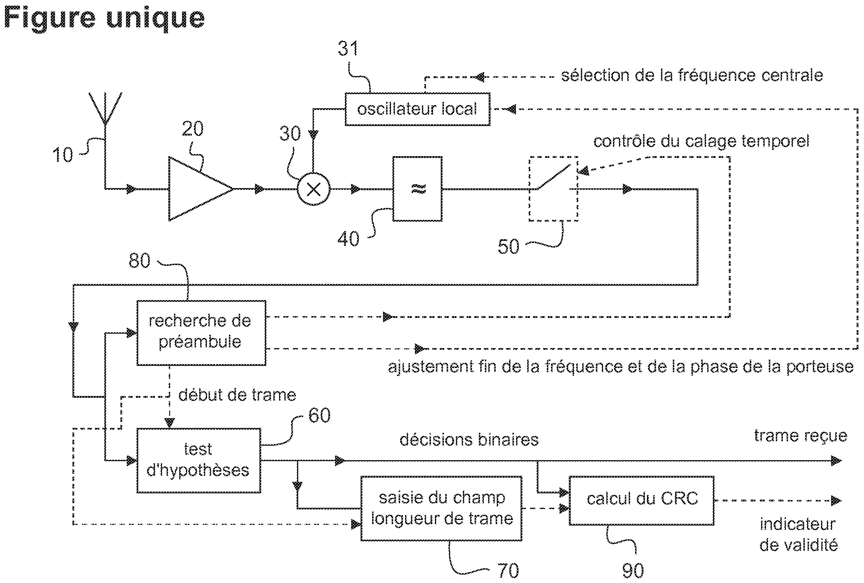

- la Figure 1 illustre schématiquement un exemple d'une architecture fonctionnelle susceptible d'être implémentée dans un récepteur mis en oeuvre dans une installation de télérelève selon l'invention.

Une installation de télérelève comprend classiquement un parc de dispositifs de comptage ou compteurs. Chaque compteur comprend un module de comptage agencé pour mesurer un volume d'eau, un volume de gaz, une consommation électrique ou autre, et un module radiofréquence comprenant pour communiquer avec un dispositif d'émission/réception/radiofréquence d'un système de passerelle de l'installation. Plus généralement, les modules de comptage du dispositif de comptage peuvent être agencés pour mesurer une consommation de fluide ou d'énergie ou autre, ou bien encore pour mesurer une valeur de paramètres. Les modules de comptage peuvent par exemple comprendre des capteurs, par exemple de température, de pression, de niveau ou autre.

Classiquement, un ou plusieurs systèmes de passerelle de l'installation communiquent d'une part, avec les dispositifs de comptage via un ou plusieurs dispositifs d'émission/réception radiofréquence et, d'autre part, avec un réseau de télécommunication externe via un dispositif concentrateur. Chaque système de passerelle transmet les données de comptage reçues des dispositifs de comptage vers le réseau de télécommunications externe.

De manière à mieux faire comprendre le procédé et le récepteur selon l'invention, la description qui suit est donnée à titre illustratif et nullement limitatif pour une installation de télérelève agencée pour la collecte des informations d'état de compteurs exploitant une bande de fréquence dite ISM définie dans la norme EN 55011, située au voisinage de 169 MHz et utilisant un format de transmission à bande étroite basé sur une modulation de fréquence d'indice voisin de 2 (représentant le nombre d'états de phase) avec un rythme symbole de 2400 bits par seconde, ce qui signifie que la fréquence de la porteuse rayonnée par un compteur durant ses périodes d'activité se trouve être décalée de sa valeur centrale qui caractérise le canal assigné au compteur, de plus ou moins 2,4 kHz durant chaque période T = 1/2400 seconde, correspondant à la transmission d'un bit, le signe de la déviation dépendant de la valeur dudit bit à transmettre.

Avant de détailler un exemple de mise en oeuvre du procédé selon l'invention, quelques rappels relatifs à la forme d'onde sont exposés. Les trames émises par les compteurs présentent un format connu a priori par le récepteur. La trame comporte par exemple une partie dédiée pour la synchronisation de la trame et plusieurs parties relatives aux données d'informations utiles à transmettre. Elle comporte ainsi une partie de préambule formée de quelques dizaines de bits sur lesquels le récepteur réalise par exemple une corrélation qui permet la détection d'un début de trame lors du franchissement d'un seuil. La partie de préambule peut également servir à l'estimation de quelques paramètres essentiels à la suite des opérations tels que la synchronisation temporelle précise ainsi que la fréquence centrale apparente telle qu'elle résulte des erreurs de calage cumulées des oscillateurs locaux de l'émetteur du compteur ainsi que du récepteur. La trame comporte ensuite un champ longueur typiquement de 8 bits, indiquant la longueur utile N de la trame comptée en octets. Puis, la trame comporte les N octets représentant l'information utile de la trame et enfin des bits de contrôle de redondance cyclique (CRC) typiquement codé sur deux octets, portant sur le champ longueur ainsi que sur le contenu d'informations utiles de la trame, soit sur un total de N+1 octets. Ainsi, le contrôle d'intégrité de la trame reçue repose dans cet exemple sur l'adjonction de deux octets calculés typiquement comme le reste d'une division polynomiale binaire portant sur la concaténation du champ longueur et du contenu d'informations utiles de la trame. Communément, l'usage des deux octets de CRC consiste en une simple vérification de l'intégrité de la trame reçue, de sorte qu'un échec lors de cette étape de vérification côté récepteur indique de façon certaine l'existence d'au moins une erreur dans la partie d'informations utiles de la trame ou dans les deux octets de contrôle.

Il convient de noter que d'autres procédés de contrôle d'intégrité aboutissant à des résultats similaires sont d'usage répandu dans le domaine des télécommunications. On citera à titre d'exemple l'adjonction d'information de validation de trame faisant appel à des fonctions dites de hachage telles que, par exemple, celles connues sous les noms de MD5 et SHA-1. Quoi qu'il en soit, on comprendra par la suite que le procédé de l'invention est applicable à la réception d'une trame dès lors qu'il existe des informations supplémentaires de validation de la trame, jouant un rôle similaire à celui des octets de CRC et qui puissent être utilisés via un calcul approprié pour valider de manière probabiliste s'entend, l'intégrité d'une trame et desdites informations supplémentaires.

La trame peut encore comporter, de manière optionnelle, un post-ambule constant indiquant la fin de la trame.

La Figure 1 illustre une architecture fonctionnelle classique d'un récepteur hétérodyne, sur la base de laquelle le procédé de l'invention peut être mis en oeuvre, étant entendu que d'autres architectures typiques pourraient également supporter le procédé de l'invention et faire l'objet de modifications similaires à celles qui vont être décrites ci-après en référence à l'architecture de récepteur selon l'exemple de la figure 1.

Ainsi, selon l'exemple de la figure 1, le signal transmis est d'abord capté par une antenne 10 du récepteur, puis transmis au bloc analogique de la chaîne de réception, comprenant un amplificateur à faible bruit 20 (LNA), un oscillateur local 31 ainsi qu'un mélangeur 30. Ces éléments ne voyant pas leur fonctionnement modifié dans le cadre de la présente invention, ils ne seront pas décrits plus en détail.

On notera simplement que le mélangeur 30, recevant sur sa première entrée le signal en sortie de l'amplificateur LNA 20, reçoit sur sa deuxième entrée, connectée à l'oscillateur local 31, une fréquence correspondant à la fréquence porteuse du signal. Ceci a pour effet de ramener le signal en bande de base. L'exemple donné ici repose sur une redescente en bande de base, mais n'est nullement limitatif, étant entendu que d'autres choix courants (tels que la sélection d'une dernière fréquence intermédiaire basse mais non-nulle) pourrait aussi être faits. Selon cet exemple, on dispose donc sen sortie du mélangeur 30, du message binaire sous forme continue en bande de base, ajouté à une composante haute fréquence centrée sur deux fois la fréquence porteuse. En effet, cette opération de démodulation fait apparaître le motif spectral du signal en bande de base, mais aussi à deux fois la fréquence de la porteuse. Aussi, un étage 40 de filtrage passe-bas en sortie du mélangeur 30 permet de supprimer la distorsion harmonique due à la redondance du spectre lors de la démodulation du signal. Le signal filtré est ensuite numérisé par un convertisseur analogique/numérique 50 fournissant une suite de bits constitutive de la trame reçue.

Les données reçues par le récepteur sont en général des données bruitées. Aussi, un décodage peut être introduit à la réception, pour prendre en considération le fait que certaines données reçues sont plus certaines que d'autres. Ainsi, pour chaque suite de bits considérée, une unité de décodage 60, également dite de décision, et nommée sur la figure 1 « test d'hypothèse » fournit en sortie une décision binaire par période symbole T (égale à 1/2400 seconde correspondant à la transmission d'un bit dans le cadre de l'exemple donné plus haut). Un tel étage de décodage 60 permet de prendre une décision ferme relativement à la valeur d'un bit de sortie, c'est-à-dire x=0 ou bien x=1, par bit entrant.

Le flux de bits en sortie est mémorisé de sorte à saisir la valeur du champ longueur de la trame reçu dans un bloc mémoire 70 et un signal de début de trame fourni par un bloc 80 de détection du préambule de la trame est utilisé pour initialiser une unité 90 de contrôle conçue pour calculer le CRC pour la trame qui suit. Le résultat du calcul de CRC est adjoint aux bits reçus pour valider ou non le contenu de la trame reçue de façon séquentielle.

Comme il a été indiqué plus haut, les deux octets de CRC sont donc communément exploités en procédant à une simple vérification de l'intégrité supposée de la trame reçue. On comprend aisément, toutes choses égales par ailleurs, c'est-à-dire à performances de détection de début de trame et de décodage en décision ferme identiques, qu'un tel usage des deux octets de CRC permet de limiter le nombre moyen de fois où le récepteur va être amené à prétendre avoir reçu une trame quand bien même aucun tel signal n'aurait été reçu. On a vu qu'il n'était pas souhaitable de viser à une diminution de ces erreurs de deuxième espèce en jouant notamment sur la valeur d'un seuil de confiance minimale pour la détection du préambule d'une trame, dans la mesure où ce type de modification entraîne une augmentation indésirable des erreurs de première espèce et partant, une diminution de la sensibilité du récepteur.

Aussi, conformément à l'invention, l'architecture typique du récepteur illustrée à la figure 1 va être modifiée de façon à obtenir un déplacement du compromis entre les deux types d'erreur dans l'autre sens. On va ainsi privilégier la sensibilité du récepteur et ainsi recevoir davantage de trames qu'on s'autorise à traiter y compris des trames erronées, c'est-à-dire qui ne satisfont pas aux contraintes induites par les octets de CRC, sachant qu'en procédant selon les principes de l'invention qui vont être détaillés ci-après, les erreurs pourront être traitées de manière à limiter l'augmentation de la fréquence moyenne d'erreurs de seconde espèce, normalement attendue dans ce contexte. Autrement dit, l'invention va permettre d'améliorer le niveau de correction sur les erreurs de première espèce, en acceptant une dégradation raisonnable en termes d'erreurs de seconde espèce.

Dans un premier temps, l'étage de décodage 60 est modifié de manière à fournir en sortie non seulement la décision binaire découlant d'une prise de décision ferme relativement à la valeur du bit reçu pendant la période symbole correspondante, mais également une valeur quantitative précise des degrés de vraisemblance conditionnelle afférant à quelle hypothèse s'avère la plus vraisemblable (à savoir le bit courant x=0 ou x=1). En d'autres termes, il convient de conserver des décisions dites souples par opposition aux décisions fermes qui se limitent à un simple bit à valeur 0 ou 1.

Ainsi, le procédé consiste dans un premier temps pour chaque suite de bits considérée à calculer la valeur d'une décision souple, cette valeur de décision souple représentant la vraisemblance de la valeur de décision ferme précédemment mentionnée.

La représentation la plus courante d'une décision souple pour un test d'hypothèse binaire consiste en la donnée du coefficient de vraisemblance logarithmique défini par :

$$d = \log \frac{P(0|r)}{P(1|r)}$$

où la barre verticale sépare selon l'usage l'hypothèse considérée de l'ensemble des observables conditionnellement auxquelles on mesure la probabilité. Ainsi, le coefficient de vraisemblance logarithmique d fournit une valeur quantitative de vraisemblance de la valeur du bit reçu définie comme le logarithme du rapport de la probabilité conditionnelle de la valeur du bit x=0 conditionnelle à la valeur r du signal reçu à la probabilité conditionnelle de la valeur du bit x=1 conditionnelle à cette même valeur r de signal reçu.

Pour illustrer la signification de l'expression de cette valeur quantitative de vraisemblance, considérons un système de transmission dans lequel le signal transmis est réel et constant à valeur $\pm\sqrt{E_b/T}$ sur chaque intervalle de temps d'une durée T, où le signe dépend d'un bit d'information utile (le signe + étant conventionnellement affecté aux bits '0'), l'inverse de T représentant le débit d'information en bits par seconde et $E_b$ étant un nombre constant homogène à l'énergie dévolue à la transmission d'un bit. On suppose disponible une version bruitée du signal transmis, le bruit additif considéré étant supposé blanc et de densité spectrale bilatère N0. Pour ce modèle d'un système de transmission à deux états de phase (usuellement dénommé MDP2 ou BPSK dans les littératures Française et Anglo-Saxonne), on montre que :

- les tests de chacune des hypothèses relatives aux bits successifs sont des problèmes indépendants les uns des autres ;
- une statistique suffisante pour chacun de ces problèmes successifs se réduit à l'évaluation de la valeur moyenne r du signal bruité reçu sur la période de durée T correspondante ;
- le rapport de vraisemblance logarithmique pour le bit en question est directement proportionnel à l'unique observable pertinente r.

On observera que r est une variable aléatoire Gaussienne de moyenne $\pm\sqrt{E_b/T}$, le signe de ladite moyenne dépendant du bit transmis, affecté d'un terme additif de moyenne nulle et de variance $N_0 T/2$.

Le taux d'erreur par décision binaire est donc égal à la probabilité que le bruit additif s'avère suffisamment grand pour conduire à l'observation d'un signal moyen r qui soit du signe opposé à celui bit transmis, ce qui arrive avec une probabilité p donnée pour un '0' émis par l'expression suivante :

$$p = P(r < 0) = Q(\sqrt{2E_b/N_0})$$

$$Q(x) \equiv \frac{1}{\sqrt{2\pi}} \int_{t=x}^{+\infty} e^{-t^2/2} dt$$

La fonction Q dans l'expression ci-dessus est la 'queue de Gaussienne' qui donne la probabilité qu'une variable normale de moyenne nulle et d'écart-type unité dépasse x, et l'expression fournie pour le taux d'erreur bit p reste bien entendu valable par symétrie quand un '1' est émis.

Le récepteur selon l'invention est ainsi conçu pour mémoriser les coefficients de vraisemblance logarithmique des valeurs de chacun des bits reçus d'une suite de bits considéré. Admettons que la saisie du champ longueur N de la trame reçue fournisse la valeur correcte de la longueur utile de trame, et que la trame comprenne 16 bits de CRC selon l'exemple exposé plus haut, alors le nombre total de bits pertinents pour N exprimé en octets valant donc M = 8.N +16.

Le récepteur procède donc au calcul des M coefficients de vraisemblance logarithmique associés aux M bits, qui seront notés $r = \{r_1,...,r_M\}$ dans ce qui suit. Compte tenu de l'indépendance statistique des M problèmes de décision déjà mentionnée, la probabilité que la suite de M bits effectivement émise soit égale à un vecteur $b = \{b_1, ...,b_M\}$ donné sachant ce que l'on a observé, à savoir r, se trouve, selon la règle de Bayes, être une fonction croissante de la quantité :

$$s = b_1 r_1 + b_2 r_2 + ... + b_M r_M \qquad (1)$$

expression dans laquelle les hypothèses $b_i$ sont représentées sous la forme '+1' pour un bit à 0 et '-1' pour un bit à 1, selon une convention homogène avec le format de transmission supposé.

La trame la plus probable correspond donc au choix du vecteur b qui maximise la somme s qui apparaît dans l'expression (1) ci-dessus. Bien entendu, la combinaison qui maximise s est celle qui assure que chacun des termes $b_i r_i$ est positif, ce qui revient à choisir $b_i$ suivant le signe du $r_i$ correspondant. Une telle combinaison est essentiellement unique sauf à considérer qu'une ou plusieurs des valeurs $r_i$ s'avère nulle, ce qui correspond à une incertitude totale sur la valeur du bit $b_i$ correspondant.

Un récepteur classique procède selon ce choix pour estimer la trame reçue, dans la mesure où cet ensemble de décisions fermes formé par le vecteur b qui maximise la somme s, constitue la seule hypothèse parmi les $2^M$ combinaisons a priori possible susceptibles d'être envisagées. C'est pourquoi, le récepteur classique n'a pas de raison particulière de préserver l'ensemble des valeurs $r_i$ de coefficients de vraisemblance logarithmique associés aux M bits reçus.

Pour l'homme du métier, il n'était pas du tout évident ni même prévisible qu'on pouvait justement avoir intérêt à préserver l'ensemble de ces valeurs de coefficients de vraisemblance logarithmique pour valider d'autres hypothèses pour la trame reçue que celle de la trame de référence fournie par la suite de bits correspondant aux décisions fermes. On aurait en effet pu craindre d'occuper des ressources du récepteur à cet effet inutilement puisque le choix pour la trame la plus probable de la trame de référence correspondant aux décisions fermes qui maximise la somme s est le choix logique et naturel. En cela, l'invention a dû vaincre un préjugé.

Pour autant, dès lors que la trame de référence formée par la suite de bits correspondant aux décisions fermes s'avère compatible avec le codage de contrôle d'intégrité employé, en l'occurrence selon l'exemple, avec la règle de calcul des deux octets de redondance cyclique, en d'autres termes si l'hypothèse sur la trame de référence ainsi estimée satisfait le test de CRC, le récepteur livre la trame résultante au monde extérieur. Sous cette seule condition, le comportement du récepteur selon l'invention est identique à celui du récepteur classique.

Il n'en va cependant plus de même lorsque l'hypothèse de base relative à la trame formée de l'ensemble des décisions fermes s'avère incompatible avec le codage de contrôle d'intégrité et donc ne satisfait pas aux contraintes induites par les deux octets de CRC. Dans un tel cas de figure, il est certain qu'un au moins des bits $b_i$ fourni par les décisions fermes est erroné. C'est alors que la préservation des valeurs $r_i$ de coefficients de vraisemblance logarithmique associés aux M bits reçus va permettre selon l'invention d'envisager d'autres hypothèses pour corriger l'estimation de la trame reçue et ce, au prix d'un effort de calcul supplémentaire modéré, qui va maintenant être décrit plus en détail.

En première approche, on pourrait songer à dresser une liste des $L = 2^M$ combinaisons possibles pour la trame reçue et à la trier selon les valeurs décroissantes des sommes correspondantes selon l'expression (1) ci-dessus. L'estimation de la trame reçue au maximum de vraisemblance sachant le vecteur r disponible consisterait à sélectionner la première entrée dans la liste triée en question qui soit compatible avec le codage de contrôle d'intégrité utilisé, et donc qui satisfasse les contraintes connues induites par la règle de calcul des octets de redondance cyclique selon l'exemple donné plus haut. Or, l'ordre de grandeur pour la liste des L combinaisons possibles est tel qu'il ne permet évidemment pas la construction effective d'une telle liste.

Au surplus, un autre obstacle en pratique est lié au nombre potentiellement très élevé de trames candidates à évaluer avant d'en trouver une qui s'avère légitime en regard de la compatibilité avec la règle de calcul des deux octets de redondance. Ce phénomène est en réalité intrinsèque au problème, et le fait que la première des trames candidates qui satisfasse effectivement les contraintes liées aux octets de redondance puisse très bien se retrouver en une position de rang très élevé est incontournable. A noter aussi qu'on fournit la trame la plus probable sachant le vecteur r disponible, atteignant ainsi la valeur au maximum de vraisemblance pour le taux d'erreurs de première espèce. Comme discuté précédemment, il est inévitable que ce choix conduise à une augmentation peut-être inacceptable des erreurs de seconde espèce.

Ainsi, deux préoccupations a priori défavorables s'imposent à l'homme du métier explorant l'approche ci-dessus, qui se traduisent d'une part, par le coût exorbitant en termes de ressources de calcul et, d'autre part, par un compromis manifestement déséquilibré entre les deux objectifs contradictoires de diminution des erreurs respectives de première et seconde espèce, dans lequel le traitement des premières se fait au détriment des secondes.

Aussi, surmontant ces préjugés, l'invention propose une méthode moins coûteuse et susceptible d'offrir un compromis plus équilibré entre les traitements des deux types d'erreur, suivant laquelle on prévoit de se concentrer uniquement sur les hypothèses susceptibles de figurer en bonne place dans la liste triée dont il est fait état plus haut. Autrement dit, on va énumérer un sous-ensemble de taille raisonnable de trames candidates ayant toutes a priori de grandes chances de figurer en bonne position dans le tri fictif de la gigantesque liste dont on se refuse pour des raisons de complexité à dresser l'inventaire, et on va examiner la compatibilité de ces trames candidates avec la règle de calcul des deux octets de redondance cyclique.

Il est clair au vu de l'expression (1) ci-dessus qu'une trame candidate qui ne diffère de la trame de référence formée de l'ensemble des décisions fermes $b_{ij} = signe(r_{ij})$ que dans quelques positions i pour lesquelles les coefficients de vraisemblance logarithmique correspondant $r_i$ sont faibles, obtiendra un score de fiabilité qui ne sera que modérément inférieur au score de référence qui maximise la somme s, à savoir $|r_1|+|r_2|+...+|r_M|$.

Aussi, selon un mode de réalisation, une méthode effective pour l'énumération des trames candidates consiste dans un premier temps, à partir de la trame de référence formée des décisions fermes $b_{ij} = signe(r_{ij})$, à sélectionner deux paramètres entiers $k \le m$ et à identifier les m plus faibles valeurs $r_i$ de coefficient de vraisemblance logarithmique en valeur absolue. Dit autrement, on va s'intéresser uniquement aux bits les plus vraisemblablement erronés pour les corriger et ainsi éviter la croissance déraisonnable d'erreurs de seconde espèce. L'énumération des trames candidates consiste alors à trier préférentiellement par ordre croissant les m plus faibles valeurs $r_i$ en valeur absolue qui ont été identifiées, de sorte que $|r_{i_1}| \le |r_{i_2}| \le |r_{i_3}|...|r_{i_m}|$, et enfin à énumérer toutes les combinaisons possibles de nombre d'inversions c parmi m positions $i_k$ en commençant préférentiellement par les valeurs de l'indice k les plus faibles, renversant les décisions fermes $b_{ij} = -signe(r_{ij})$ pour c valeurs de j parmi m et conservant les décisions fermes pour les autres bits afin de former une nouvelle trame candidate et ce, pour un nombre de positions à inverser c = 0,1,2...k.

De préférence, à chaque itération de l'énumération ci-dessus, on procède à une vérification de la compatibilité de la trame candidate de l'itération courante avec les règles de calcul du code de contrôle de redondance cyclique et on arrête les itérations dès lors qu'une trame candidate testée s'avère légitime, i.e. présente un CRC compatible avec les règles en vigueur.

Ainsi, selon ce mode de réalisation, on procède par approches successives en éliminant progressivement les trames candidates énumérées selon l'ordonnancement prédéfini par ordre croissant de leur fiabilité et par ordre croissant du nombre d'inversion des bits les plus vraisemblablement erronés et en ne conservant qu'une gamme restreinte d'hypothèses tendant vers celle qui est optimale.

On trouvera ci-après un exemple illustrant ce mode de réalisation. Soit l'ensemble des trames candidates considérées pour une trame reçue quand les paramètres d'énumération sont m = 3, k = 2. Pour alléger les notations, on ne fournit que les {positions des bits} auxquelles la trame candidate diffère par complémentation du bit en question de la trame de référence fournie par les décisions fermes. Les trois entiers $i_1$ à $i_3$ désignent les trois bits les moins fiables de la trame reçue.

| Trame candidate | Nombre d'inversions | Commentaires |
| --- | --- | --- |
| { } | 0 | On commence par la trame de référence |
| {$i_1$} | 1 | Inversion du bit le moins fiable |
| {$i_2$} | 1 | Passage au bit suivant |
| {$i_3$} | 1 | ... |
| {$i_1$, $i_2$} | 2 | Inversion de 2 bits douteux |
| {$i_1$, $i_3$} | 2 | ... |
| {$i_2$, $i_3$} | 2 | Dernière trame candidate |

Selon ce mode de réalisation, il convient de noter que l'ordre dans lequel on examine les trames candidates peut s'avérer important, dès lors que l'on arrête les itérations à la première trame candidate qui vérifie les règles de calculs des octets de CRC, étant entendu que même pour des valeurs modérées du nombre d'inversion c, il se peut que plusieurs telles trames candidates s'avèrent légitimes, c'est-à-dire présentent un CRC compatible. C'est pourquoi, il est souhaitable d'effectuer l'énumération des trames candidates selon l'ordonnancement suggéré ci-dessus, consistant à commencer l'énumération des trames candidates par les indices k faibles, qui correspondent aux bits les moins fiables, et à énumérer les combinaisons à peu d'inversions avant celles comprenant de nombreuses inversions, i.e. à itérer sur le nombre d'inversions c dans l'ordre croissant.

On notera toutefois que ceci ne garantit pas que l'on énumère les trames candidates par ordre de score résultant décroissant. Ainsi, considérant l'exemple ci-dessus, si par exemple le troisième coefficient de vraisemblance logarithmique dépasse en valeur absolue la somme de ses deux prédécesseurs, soit si $|r_{i_3}| > |r_{i_1}| + |r_{i_2}|$, alors dans ce cas de figure, la quatrième trame candidate $\{i_3\}$ présentera un score inférieur à la cinquième trame candidate $\{i_1, i_2\}$, tout en étant pourtant énumérée avant, suivant l'ordonnancement retenu ci-dessus. Aussi, partant de l'hypothèse défavorable où les deux trames candidates en question s'avéreraient présenter un CRC compatible, le fait de livrer la trame candidate $\{i_3\}$ comme résultat de l'estimation de la trame reçue par le récepteur, conduirait à une erreur de seconde espèce (i.e. une trame erronée) dont la cause première serait ici une sagacité insuffisante du récepteur plutôt qu'un 'faux départ' du récepteur, à supposer qu'une véritable trame ait effectivement conduit au déclenchement de la procédure décrite ici.

Aussi, une variante de la procédure d'énumération décrite dans le mode de réalisation ci-dessus, consiste, plutôt que de s'arrêter à la première trame candidate légitime, à pousser la procédure d'énumération des trames candidates à son terme, à mémoriser pour chaque trame candidate énumérée les scores de fiabilité correspondant, puis à sélectionner ensuite la trame candidate présentant le score de fiabilité le plus élevé parmi les trames candidates légitimes.

On a supposé dans ce qui précède que le champ longueur de la trame était connu de façon fiable. Bien entendu, les bits qui forment le champ longueur subissent les mêmes effets délétères dus au bruit additifs que les autres bits de la trame, et sont eux-mêmes susceptibles d'être affectés d'une ou plusieurs erreurs. Compte tenu du fait que la valeur retenue pour le champ longueur influe de façon décisive sur la manière dont il convient de calculer la conformité des informations redondantes (en l'occurrence les deux octets de CRC dans le cas du format du trame utilisé dans les installations de collecte d'informations d'état de compteurs selon l'exemple donné plus haut), il peut être utile pour limiter les pertes d'étendre le bénéfice de la phase de décision finale quant à l'information utile de la trame reçue au champ longueur lui-même.

Pour ce faire, on prévoit de traiter le champ longueur séparément du reste de la trame et de se ramener à deux instances du problème précédemment traité. Compte tenu de la très faible taille en bits du champ longueur (typiquement 8 bits pour les formats de transmission courants), il n'est pas nécessaire de considérer plus de deux valeurs candidates pour le champ longueur reçu, bien qu'il ne soit nullement exclu cependant de considérer plus de deux valeurs candidates pour le champ longueur.

Ainsi, après réception des 8 premiers bits, deux valeurs candidates pour le champ longueur sont considérées, l'une correspondant aux 8 décisions fermes, l'autre obtenue par inversion du bit le moins fiable des 8 bits en question. Soient $N_1$ et $N_2$ ces deux valeurs, avec $N_1 < N_2$. On procède ensuite à la réception des $8.N_1+16$ bits suivants, en identifiant les m plus faibles valeurs $r_i$ de coefficient de vraisemblance logarithmique en valeur absolue, de manière à procéder à une première exécution du processus de sélection de la trame candidate selon les principes exposés ci-dessus. Dans sa variante simple selon laquelle on considère avoir reçu une trame valide dès lors qu'une des trames candidates énumérées s'avère légitime, i.e. s'avère compatible avec le codage de contrôle d'intégrité retenu, on s'arrête effectivement si l'une des trames candidates se trouve satisfaire cette condition requise. Si tel n'est pas le cas, dit autrement aucune trame candidate légitime identifiée, il convient alors d'envisager la seconde hypothèse retenue pour le champ longueur, à savoir la possibilité que $N_2$ soit la bonne valeur candidate pour le champ longueur au lieu de $N_1$ précédemment retenue, et on étend la phase de réception de sorte à collecter les $N_2 - N_1$ bits manquants et on recommence le processus de sélection de la trame candidate basé cette fois-ci sur la plus grande des deux longueurs de trame envisagées.

Au final, la présente invention génère un surcoût minime, qui s'avère lié à la nécessité de mémoriser un ensemble de m informations représentant chacune l'une des décisions les plus vraisemblablement erronées, dit autrement les moins fiables, reçues depuis le début de la trame, à savoir au minimum le rang du bit concerné $i_j$ et la valeur du coefficient de vraisemblance logarithmique associé $r_{ij}$. La mise à jour de cet ensemble d'informations après réception d'un bit supplémentaire comprend des opérations élémentaires visant à comparer le coefficient de vraisemblance logarithmique du dernier bit reçu avec le plus grand en valeur absolue des m valeurs préservées, et à réorganiser l'ensemble en question de sorte à maintenir cet ensemble des m plus faibles valeurs reçues traitées de façon séquentielle. Un mode de réalisation pour effectuer cette mise à jour peut consister à conserver une image de ces m valeurs les moins fiables, ordonnées par valeurs croissantes de leur coefficient de leur coefficient vraisemblance logarithmique associé (ou décroissantes), la mise à jour lors de la réception d'un nouvel élément comprenant alors la comparaison avec le dernier élément (tri croissant) ou le premier élément (tri décroissant) et, en cas de nécessité, l'acceptation du nouvel élément et l'insertion de celui-ci au bon rang de sorte à préserver la nature ordonnée de l'ensemble actualisé.

Nous allons maintenant décrire un mode de réalisation préféré pour le calcul d'un CRC afin de procéder à l'évaluation du CRC des différentes trames candidates correspondant aux différentes tentatives d'inversion des décisions fermes. A cet effet, il convient d'abord de préciser la nature du calcul d'un CRC à 16 bits selon le format retenu dans l'exemple cité plus haut d'installation de collecte d'informations d'état de compteurs.

On note $n$ le nombre total de bits intervenant dans le calcul du CRC, soit $n = 8 + 8.N$, où N est la valeur supposée du champ longueur donnée par les 8 premiers bits, de sorte que le calcul de reste, qui constitue le coeur de l'algorithme de codage de contrôle d'intégrité consiste à effectuer une division Euclidienne comme indiqué ci-après :

$$g(x) = x^{16} + x^{12} + x^5 + 1$$
$$i(x) = (x^{16} + 1)/(x+1) = x^{15} + x^{14} + x^{13} + \ldots + x^2 + x + 1$$
$$d_j(x) = x^j i(x) + b_1 x^{j-1} + b_2 x^{j-2} + \ldots + b_{j-1} x + b_j \tag{2}$$
$$d_j(x) = q_j(x) g(x) + c_j(x), \deg(c_j) < \deg(g) = 16$$

Tous les polynômes considérés ici sont à coefficients dans le corps à deux éléments {0,1} muni des opérations usuelles de l'arithmétique modulo 2. Le polynôme $g$ en la variable formelle $x$ est le générateur du code cyclique sous-jacent, le polynôme $d_j$ représente les $j$ premières données binaires entrantes pour lesquelles on désire calculer le CRC représenté par le reste $c_j$ de la division Euclidienne usuelle sur le corps binaire à deux éléments définie par la quatrième ligne de l'équation (2) ci-dessus, étant entendu que la valeur des quotients $q$ ne présente aucun intérêt particulier, seul le reste $c_n$ représentant les 16 bits du résultat final après assimilation de tous les bits. Le polynôme constant $i(x)$ joue le rôle d'une constante additive dont l'effet est d'affecter le résultat final, de sorte qu'aucune des deux suites d'informations {$b_j$} particulières formées exclusivement de $n$ zéros et de $n$ uns, respectivement, ne fournisse un reste $c$ lui-même formé exclusivement de zéros ou de uns. Bien que l'équation (2) mentionne tous les résultats intermédiaires, on ne s'intéresse qu'à seule la valeur finale quand $j = n$.

Le calcul du reste $c_j$ peut être réalisé en pratique de façon itérative comme suit. On initialise un registre $c$ de 16 bits (que nous représenterons ici avec les coefficients des puissances de x élevées à gauche / en premier) à la valeur 1111111111111111, qui correspond à la constante $i(x)$. Le registre $c$ en question représente la valeur du résultat inter-médiaire $c_j$ après avoir reçu $j$ bits, et la valeur initiale ci-dessus correspond à $j = 0$.

Ensuite, pour les valeurs successives de l'indice $j$ allant de 1 à $n$, on incorpore la contribution du bit $b_j$ en procédant comme suit : on multiplie $c_j$ par x, ce qui revient à un décalage vers la gauche d'un cran, et on lui ajoute le polynôme $b_j x^0$ ce qui revient à remplacer le bit de droite du registre $c_j$ par le bit entrant $b_j$. Si ce résultat intermédiaire comporte un terme en $x^{16}$ non nul, on ajoute (au sens du corps à deux éléments) le polynôme $g$ à $c_j$ de sorte à annuler ce terme en $x^{16}$ et à maintenir la propriété désirée $\deg(c_j) < 16$. Cet ajout est réalisé en pratique par une opération de type OU-Exclusif bit-à-bit entre le registre $c_j$ décalé de 1 bit vers la gauche et la constante g représentée comme (1)0001000000100101, où l'on a indiqué entre parenthèses le coefficient en $x^{16}$ qui n'intervient pas vu que le registre $c_j$ n'a besoin que de 16 bits.

Il est très facile de vérifier par récurrence sur l'indice $j$ que la valeur mise à jour selon ce procédé de $c_j$ est bien celle définie par l'équation (4), de sorte qu'après $n$ telles opérations, le résultat $c_n$ est bien le CRC désiré.

Il est possible d'adjoindre à chacune des m informations préservées, qui caractérisent les m positions binaires les moins fiables rencontrées jusqu'à la position courante, un registre à 16 bits qui fournisse le changement du résultat final $c_n$ (sous forme d'où-exclusifs bit-a-bit portant sur les 16 positions binaires) dans l'hypothèse ou l'on serait amené à inverser la décision ferme correspondante.

Il convient alors d'initialiser le registre de 16 bits correspondant avec la valeur constante 0000000000000001 lorsque le coefficient de vraisemblance logarithmique courant $r_j$ est suffisamment faible en valeur absolue pour rejoindre le sous-ensemble des positions les moins fiables que l'on préserve pour la phase de décision finale. Il convient également de mettre à jour les m registres de 16 bits correspondant aux changements éventuels du CRC final lors de l'assimilation des données entrantes restantes.

La phase active d'énumération des hypothèses sur la trame finale peut alors se réduire à de très simples opérations visant à modifier le CRC de la trame de référence via de simples opérations de type ou-exclusif sur 16 bits avec un sous ensemble des bits les moins fiables pour lesquels on désire renverser la décision ferme de référence.

## Revendications

**1.** Procédé de réception de données numériques transmises par trames utilisant un codage de contrôle d'intégrité par lequel, avant une étape de transmission d'une trame sur un canal, on adjoint à la trame une information supplémentaire de validation de trame créée à l'aide dudit codage de contrôle d'intégrité et, après ladite étape de transmission sur ledit canal, on procède à une estimation de la trame reçue au moyen d'une unité de décision permettant de déterminer une trame de référence par décisions fermes relativement à la valeur de chaque bit reçu d'une suite de bits de longueur N considérée et on procède à une vérification de la compatibilité de ladite trame de référence fournie par les décisions fermes avec ledit codage de contrôle d'intégrité utilisé, ledit procédé comprenant des étapes consistant, pour chaque trame reçue :

- à calculer, pour chaque bit de ladite trame de référence fournie par les décisions fermes, une valeur de vraisemblance de la valeur du bit reçu représentative de la probabilité d'erreur de transmission pour les bits considérés ;

et, en cas de non-compatibilité de ladite trame de référence avec ledit codage de contrôle d'intégrité :

- à identifier dans ladite trame de référence un ensemble fini non vide de bits les plus vraisemblablement erronés en fonction desdites valeurs de vraisemblance calculées pour chaque bit ;
- à énumérer une pluralité de trames candidates correspondant chacune respectivement à l'une des combinaisons possibles de nombre d'inversions des bits les plus vraisemblablement erronés identifiés dans ladite trame de référence ;
- à vérifier la compatibilité des trames candidates de ladite pluralité de trames candidates énumérées avec ledit codage de contrôle d'intégrité ;
- à sélectionner une trame candidate compatible avec ledit codage de contrôle d'intégrité afin d'estimer la trame reçue, ledit procédé étant **caractérisé en ce qu'**il comprend en outre des étapes consistant à recevoir un premier ensemble de bits donnant la longueur de la trame, à considérer au moins deux valeurs candidates de longueur de trame déterminées en fonction des valeurs de vraisemblance calculées pour chaque bit dudit premier ensemble de bits, et à procéder à l'estimation de la trame reçue, selon les étapes précédentes, dans l'ordre croissant des longueurs de trame considérées, successivement.

2. Procédé selon la revendication 1, **caractérisé en ce qu'**il comprend des étapes consistant à ordonner l'énumération de chaque trame candidate par ordre croissant de leur fiabilité et par ordre croissant du nombre d'inversions des bits les plus vraisemblablement erronés identifiés dans ladite trame de référence et à vérifier itérativement la compatibilité des trames candidates ainsi ordonnées, de sorte à arrêter les itérations dès qu'une trame candidate est vérifiée compatible avec ledit codage de contrôle d'intégrité, par quoi ladite trame candidate sélectionnée est celle de l'itération courante.

3. Procédé selon la revendication 1, **caractérisé en ce qu'**il comprend des étapes consistant :

- à déterminer pour chaque trame candidate de ladite pluralité de trames candidates énumérées un score de fiabilité résultant de la somme desdites valeurs de vraisemblance calculées pour chaque bit, pondérées en fonction de la valeur du bit correspondant dans ladite trame candidate ;
- à sélectionner la trame candidate parmi ladite pluralité de trames candidates énumérées qui maximise ledit score de fiabilité tout en étant compatible avec ledit codage de contrôle d'intégrité.

4. Procédé selon l'une quelconque des revendications précédentes, **caractérisé en ce que** lesdites au moins deux valeurs candidates de longueur de trame considérées comprennent une première valeur candidate de longueur de trame obtenue par décisions fermes relativement à la valeur de chaque bit reçu dudit premier ensemble de bits et une deuxième valeur candidate de longueur de trame obtenue par inversion du bit le plus vraisemblablement erroné dudit premier ensemble de bit.

5. Procédé selon l'une quelconque des revendications précédentes, **caractérisé en ce que** l'identification dans ladite trame de référence dudit ensemble fini non vide de bits les plus vraisemblablement erronés consiste à mémoriser depuis le début de réception de la trame un ensemble d'information comprenant au moins la position des bits concernés dans la trame et la valeur de vraisemblance associée et à mettre à jour ledit ensemble d'informations après réception de chaque bit supplémentaire, ladite mise à jour consistant à comparer la valeur de vraisemblance associée audit bit supplémentaire reçu avec la plus grande en valeur absolue des valeurs de vraisemblance préalablement mémorisées, et à modifier ledit ensemble d'informations, de sorte à remplacer la plus fiable des positions mémorisées par la position dudit bit supplémentaire reçu si celui-ci s'avère moins fiable.

6. Procédé selon l'une quelconque des revendications précédentes, **caractérisé en ce que** lesdites valeurs de vraisemblance calculées pour chaque bit reçu résultent du calcul du coefficient de vraisemblance logarithmique de la valeur du bit reçu défini par le logarithme du rapport de la probabilité conditionnelle que le bit reçu est dans un premier état compte tenu de la valeur du bit reçu à la probabilité conditionnelle que le bit reçu est dans un second état compte tenu de cette même valeur du bit reçu.

7. Procédé selon l'une quelconque des revendications précédentes, **caractérisé en ce que** ledit codage de contrôle d'intégrité est effectué par un codage de contrôle de redondance cyclique.

**8.** Procédé selon l'une quelconque des revendications 1 à 6, **caractérisé en ce que** ledit codage de contrôle d'intégrité est effectué par un algorithme de hachage.

**9.** Procédé selon l'une quelconque des revendications précédentes, **caractérisé en ce qu'**il est mis en oeuvre par un dispositif d'émission/réception radiofréquence d'un système de passerelle dans une installation de télérelève comprenant en outre une pluralité de dispositifs de comptage, chaque dispositif de comptage comprenant un module de comptage et un module radiofréquence pour transmettre des données à destination dudit dispositif d'émission/réception radiofréquence dudit système de passerelle.

**10.** Dispositif de réception de données numériques transmises par trames utilisant un codage de contrôle d'intégrité, du type comprenant une unité de décision (60) agencée de façon à fournir en sortie des décisions fermes relativement à la valeur de chaque bit reçu d'une suite de bits de longueur N considérée, l'ensemble desdites décision fermes constituant une trame de référence correspondant à une estimation d'une trame reçue, et une unité de contrôle (90) agencée pour calculer une information de validation de trame apte à fournir une indication de la compatibilité de la trame reçue avec ledit codage de contrôle d'intégrité utilisé, ladite unité de décision (60) comprenant :

- des moyens de calculs d'une valeur de vraisemblance de la valeur du bit reçu représentative de la probabilité d'erreur de transmission pour chaque bit reçu de ladite trame de référence,
- des moyens de mémorisation d'un ensemble fini non vide de bits les plus vraisemblablement erronés de ladite trame de référence en fonction desdites valeurs de vraisemblance calculées pour chaque bit,
- des moyens de décision agencés pour énumérer une pluralité de trames candidates correspondant chacune respectivement à l'une des combinaisons possibles de nombre d'inversions des bits les plus vraisemblablement erronés, ladite unité de contrôle (90) étant conçue pour vérifier la compatibilité des trames candidates de ladite pluralité de trames candidates énumérées avec ledit codage de contrôle d'intégrité, lesdits moyens de décision étant agencés pour sélectionner une trame candidate compatible avec ledit codage de contrôle d'intégrité afin d'estimer la trame reçue, ledit dispositif étant **caractérisé en ce que** ladite unité de décision étant en outre adaptée pour recevoir un premier ensemble de bits donnant la longueur de la trame, considérer au moins deux valeurs candidates de longueur de trame déterminées en fonction des valeurs de vraisemblance calculées pour chaque bit dudit premier ensemble de bits, et procéder à l'estimation de la trame reçue par l'intermédiaire des dits moyens dans l'ordre croissant des longueurs de trame considérées, successivement.

**11.** Système de passerelle pour une installation de télérelève, ledit système de passerelle comprenant au moins un dispositif d'émission/réception radiofréquence pour communiquer avec une pluralité de dispositifs de comptage de ladite installation de télérelève, ledit dispositif d'émission/réception radiofréquence comprenant un dispositif de réception selon la revendication 10.

**12.** Dispositif de comptage pour une installation de télérelève du type comprenant un module de comptage et un module radiofréquence pour communiquer avec un dispositif d'émission/réception/radiofréquence d'un système de passerelle de ladite installation de télérelève, ledit module radiofréquence comprenant un dispositif de réception selon la revendication 10.

**13.** Installation de télérelève notamment de compteurs d'eau, comprenant une pluralité de dispositifs de comptage selon la revendication 12 et au moins un système de passerelle selon la revendication 11.

**Patentansprüche**

**1.** Verfahren zum Empfangen von Digitaldaten, die mit Datenrahmen unter Verwendung einer Integritätsprüfungscodierung übertragen werden, mit der vor dem Schritt der Übertragung eines Rahmens auf einem Kanal dem Rahmen eine zusätzliche Informationen zur Rahmenbestätigung zugefügt wird, die mithilfe der Integritätsprüfungscodierung geschaffen wird, und nach dem Schritt mit der Übertragung auf dem Kanal wird eine Schätzung des empfangenen Rahmens vermittels einer Entscheidungseinheit durchgeführt, mit der ein Referenzrahmen durch feste Entscheidungen bezüglich des Werts jedes empfangenen Bits einer Bitfolge mit der betrachteten Länge N bestimmt werden kann, und es wird eine Kompatibilitätsprüfung des durch die festen Entscheidungen empfangenen Referenzrahmens mit der benutzten Integritätsprüfungscodierung durchgeführt, wobei das Verfahren Schritte umfasst, die für jeden empfangenen Rahmen aus Folgendem bestehen:

- für jedes Bit des durch feste Entscheidungen bereitgestellten Referenzrahmens einen Wahrscheinlichkeitswert des Werts des empfangenen Bits zu berechnen, der repräsentativ für die Übertragungsfehler-Wahrscheinlichkeit für die betrachteten Bits ist;

und im Fall einer Inkompatibilität des Referenzrahmens mit der Integritätsprüfungscodierung:

- im Referenzrahmen eine abgeschlossene nicht leere Reihe von am Wahrscheinlichsten fehlerhaften Bits je nach den für jedes Bit berechneten Wahrscheinlichkeitswerten zu identifizieren;
- eine Mehrzahl von Anwärterrahmen aufzuzählen, die jeweils einer der möglichen Kombinationen von Bitumkehranzahlen entsprechen, die am Wahrscheinlichsten fehlerhaft sind und im Referenzrahmen identifiziert werden;
- die Kompatibilität der Anwärterrahmen der Mehrzahl von Anwärterrahmen zu überprüfen, die mit der Integritätsprüfungscodierung aufgezählt wurden;
- einen mit der Integritätsprüfungscodierung kompatiblen Anwärterrahmen auszuwählen, um den empfangenen Rahmen zu schätzen,

wobei das Verfahren **dadurch gekennzeichnet ist, dass** es ferner Schritte umfasst, die darin bestehen, eine erste Gruppe von Bits zu empfangen, die die Länge des Rahmens angibt, zumindest zwei Anwärterwerte mit Rahmenlängen zu betrachten, die je nach den für jedes Bit der ersten Bitgruppe berechneten Wahrscheinlichkeitswerten bestimmt sind, und die Schätzung des bei den vorherigen Schritten empfangenen Rahmens vorzunehmen, in aufsteigender Reihenfolge der nacheinander betrachteten Rahmenlängen.

2. Verfahren nach Anspruch 1, **dadurch gekennzeichnet, dass** es Schritte umfasst, die darin bestehen, die Aufzählung jedes Anwärterrahmens in aufsteigender Reihenfolge ihrer Zuverlässigkeit und in aufsteigender Reihenfolge der Bitumkehranzahlen zu ordnen, die am Wahrscheinlichsten fehlerhaft sind und im Referenzrahmen identifiziert werden und inkrementweise die Kompatibilität der so geordneten Anwärterrahmen zu überprüfen, so dass die Inkrementierungen beendet werden, sobald sich ein Anwärterrahmen bei Prüfung als mit der Integritätsprüfungscodierung kompatibel herausstellt, wodurch der gewählte Anwärterrahmen derjenige der aktuellen Inkrementierung ist.

3. Verfahren nach Anspruch 1, **dadurch gekennzeichnet, dass** es Schritte umfasst, die aus Folgendem bestehen:

- für jeden Anwärterrahmen der Mehrzahl von aufgezählten Anwärterrahmen eine Zuverlässigkeitszahl zu bestimmen, die aus der Summe der Wahrscheinlichkeitswerte hervorgeht, die für jedes Bit berechnet und je nach dem Wert des entsprechenden Bits im Anwärterrahmen gewichtet werden;
- den Anwärterrahmen unter der Mehrzahl von aufgezählten Anwärterrahmen auszuwählen, der die Zuverlässigkeitszahl maximiert und gleichzeitig mit der Integritätsprüfungscodierung kompatibel ist.

4. Verfahren nach einem der vorstehenden Ansprüche, **dadurch gekennzeichnet, dass** die zumindest zwei betrachteten Anwärterwerte mit Rahmenlänge einen ersten Anwärterwert mit Rahmenlänge umfassen, der durch feste Entscheidungen bezüglich des Werts jedes empfangenen Bits der ersten Bitgruppe erzielt wird, und einen zweiten Anwärterwert mit Rahmenlänge, der durch Umkehr des am Wahrscheinlichsten fehlerhaften Bits der ersten Bitgruppe erzielt wird.

5. Verfahren nach einem der vorstehenden Ansprüche, **dadurch gekennzeichnet, dass** die Identifizierung der abgeschlossenen nicht leeren Reihe von am Wahrscheinlichsten fehlerhaften Bits im Referenzrahmen darin besteht, ab dem Beginn des Empfangs des Rahmens eine Reihe von Daten zu speichern, die zumindest die Position der betroffenen Bits im Rahmen und den zugehörigen Wahrscheinlichkeitswert umfassen, und die Datenreihe nach dem Empfang jedes zusätzlichen Bits zu aktualisieren, wobei die Aktualisierung darin besteht, den zum empfangenen zusätzlichen Bit zugehörigen Wahrscheinlichkeitswert mit dem größten dem Absolutwert nach der vorher gespeicherten Wahrscheinlichkeitswerte zu vergleichen und die Datenreihe zu ändern, so dass die zuverlässigste der gespeicherten Positionen durch die Position des empfangenen zusätzlichen Bits ersetzt wird, wenn dieses sich als weniger zuverlässig herausstellt.

6. Verfahren nach einem der vorstehenden Ansprüche, **dadurch gekennzeichnet, dass** die für jedes erhaltene Bit berechneten Wahrscheinlichkeitswerte aus der Berechnung des logarithmischen Wahrscheinlichkeitskoeffizienten des Werts des erhaltenen Bits resultieren, der durch den Logarithmus des bedingten Wahrscheinlichkeitsverhältnisses definiert wird, dass sich das empfangene Bit angesichts des Werts des empfangenen Bits in einem ersten Zustand befindet, mit der bedingten Wahrscheinlichkeit, dass sich das empfangene Bit angesichts dieses gleichen Werts des empfangenen Bits in einem zweiten Zustand befindet.

7. Verfahren nach einem der vorstehenden Ansprüche, **dadurch gekennzeichnet, dass** die Integritätsprüfungscodierung mit einer zyklischen Redundanz-Codierung durchgeführt wird.

8. Verfahren nach einem der vorstehenden Ansprüche 1 bis 6, **dadurch gekennzeichnet, dass** die Integritätsprüfungscodierung mit einem Hash-Algorithmus durchgeführt wird.

9. Verfahren nach einem der vorstehenden Ansprüche, **dadurch gekennzeichnet, dass** es mit einer Radiofrequenz-Sende-/Empfangsvorrichtung eines Gateway-Systems in einer Fernablesungsanlage eingesetzt wird, die ferner eine Mehrzahl von Zählvorrichtungen umfasst, wobei jede Zählvorrichtung ein Zählmodul und ein Radiofrequenzmodul für die Übertragung von Daten an die Radiofrequenz-Sende-/Empfangsvorrichtung des Gateway-Systems umfasst.

10. Vorrichtung zum Empfangen von Digitaldaten, die mit Datenrahmen unter Verwendung einer Integritätsprüfungscodierung übertragen werden, und zwar vom Typ, der eine Entscheidungseinheit (60) umfasst, die so gestaltet ist, dass sie am Ausgang feste Entscheidungen bezüglich des Werts jedes empfangenen Bits einer Bitfolge mit der betrachteten Länge N liefert, wobei alle festen Entscheidungen einen Referenzrahmen bilden, der einer Schätzung eines empfangenen Rahmens entspricht, und eine Kontrolleinheit (90), die so gestaltet ist, dass sie eine Information zur Bestätigung des Rahmens berechnet, die geeignet ist, eine Angabe zur Kompatibilität des empfangenen Rahmens mit der Integritätsprüfungscodierung zu liefern, wobei die Entscheidungseinheit (60) Folgendes umfasst:

- Mittel zur Berechnung eines Wahrscheinlichkeitswerts des empfangenen Bits, der repräsentativ für die Übertragungsfehler-Wahrscheinlichkeit des Referenzrahmens für jedes empfangene Bit ist,
- Mittel zur Speicherung einer abgeschlossenen nicht leeren Reihe von am Wahrscheinlichsten fehlerhaften Bits des Referenzrahmens je nach den für jedes Bit berechneten Wahrscheinlichkeitswerten,
- Mittel zur Entscheidung, die so gestaltet sind, dass sie eine Mehrzahl von Anwärterrahmen aufzählen, die jeweils einer der möglichen Kombinationen von Bitumkehranzahlen entsprechen, die am Wahrscheinlichsten fehlerhaft sind, wobei die Kontrolleinheit (90) so konzipiert ist, dass sie die Kompatibilität der Anwärterrahmen der Mehrzahl von Anwärterrahmen überprüft, die mit der Integritätsprüfungscodierung aufgezählt wurden, wobei die Entscheidungsmittel so gestaltet sind, dass sie einen mit der Integritätsprüfungscodierung kompatiblen Anwärterrahmen auswählen, um den empfangenen Rahmen zu schätzen, wobei die Vorrichtung **dadurch gekennzeichnet ist, dass** die Entscheidungseinheit ferner geeignet ist, eine erste Gruppe von Bits zu empfangen, die die Länge des Rahmens angibt, zumindest zwei Anwärterwerte mit Rahmenlängen zu betrachten, die je nach den für jedes Bit der ersten Bitgruppe berechneten Wahrscheinlichkeitswerten bestimmt sind, und die Schätzung des Rahmens vorzunehmen, der vermittels der Mittel empfangen wird, nacheinander in aufsteigender Reihenfolge der betrachteten Rahmenlängen.

11. Gateway-System für eine Fernablesungsanlage, wobei das Gateway-System zumindest eine Radiofrequenz-Sende-/Empfangsvorrichtung umfasst, um mit einer Mehrzahl von Zählvorrichtungen der Fernablesungsanlage zu kommunizieren, wobei die Radiofrequenz-Sende-/Empfangsvorrichtung eine Empfangsvorrichtung nach Anspruch 10 umfasst.

12. Zählvorrichtung für eine Radiofrequenz-Sende-/Empfangsvorrichtung vom Typ, der ein Zählmodul und ein Radiofrequenzmodul umfasst, um mit einer Radiofrequenz-Sende-/Empfangsvorrichtung eines Gateway-Systems der Fernablesungsanlage zu kommunizieren, wobei das Radiofrequenzmodul eine Empfangsvorrichtung nach Anspruch 10 umfasst.

13. Fernablesungsanlage insbesondere für Wasserzähler, die eine Mehrzahl von Zählvorrichtungen nach Anspruch 12 und zumindest ein Gateway-System nach Anspruch 11 umfasst.

## Claims

1. A method for receiving digital data transmitted by frames using an integrity check coding by which, before a step of transmission of a frame over a channel, an additional frame validation information item created using said integrity check coding is added to the frame and, after said step of transmission over said channel, an estimation of the received frame is carried out by means of a decision unit making it possible to determine a reference frame by firm decisions concerning the value of each bit received of a series of bits of length N considered and a verification of the compatibility of said reference frame supplied by the firm decisions is carried out with said integrity check coding used, said method being **characterized in that** it comprises steps consisting, for each frame received:

- in calculating, for each bit of said reference frame supplied by the firm decisions, a value of likelihood of the value of the received bit representative of the probability of transmission error for the bits considered;

and, in case of non-compatibility of said reference frame with said integrity check coding:

- in identifying in said reference frame a non-empty finite set of bits most likely errored as a function of said likelihood values calculated for each bit;
- in listing a plurality of candidate frames each corresponding respectively to one of the possible combinations of a number of inversions of the bits most likely errored identified in said reference frame;
- in verifying the compatibility of the candidate frames of said plurality of candidate frames listed with said integrity check coding;
- in selecting a candidate frame compatible with said integrity check coding for estimating the frame received,

said method further comprising steps consisting in receiving a first set of bits giving the length of the frame, in considering at least two candidate frame length values determined as a function of the likelihood values calculated for each bit of said first set of bits, and in carrying out the estimation of the frame received according the preceding steps in ascending order of the frame lengths considered, in succession.

2. The method as claimed in claim 1, **characterized in that** it comprises steps consisting in ordering the listing of each candidate frame in ascending order of their reliability and in ascending order of the number of inversions of the bits most likely errored identified in said reference frame and in iteratively verifying the compatibility of the duly ordered candidate frames, so as to stop the iterations as soon as a candidate frame is verified as compatible with said integrity check coding, whereby said selected candidate frame is that of the current iteration.

3. The method as claimed in claim 1, **characterized in that** it comprises steps consisting:

- in determining, for each candidate frame of said plurality of candidate frames listed, a reliability score resulting from the sum of said likelihood values calculated for each bit, weighted as a function of the value of the corresponding bit in said candidate frame;
- in selecting the candidate frame from said plurality of candidate frames listed which maximizes said reliability score while being compatible with said integrity check coding.

4. The method as claimed in any one of the preceding claims, **characterized in that** said at least two candidate frame length values considered comprise a first candidate frame length value obtained by firm decisions concerning the value of each bit received of said first set of bits and a second candidate frame length value obtained by inversion of the bit most likely errored of said first set of bits.

5. The method as claimed in any one of the preceding claims, **characterized in that** the identification in said reference frame of said non-empty finite set of bits most likely errored consists in storing, from the start of reception of the frame, a set of information comprising at least the position of the bits concerned in the frame and the associated likelihood value and in updating said set of information after reception of each additional bit, said updating consisting in comparing the likelihood value associated with said additional bit received with the greatest in absolute value of the likelihood values previously stored, and in modifying said set of information, so as to replace the most reliable of the stored positions with the position of said additional bit received if the latter proves less reliable.

6. The method as claimed in any one of the preceding claims, **characterized in that** said likelihood values calculated for each bit received result from the calculation of the logarithmic likelihood coefficient of the value of the bit received defined by the logarithm of the ratio of the conditional probability that the bit received is in a first state given the value of the bit received to the conditional probability that the bit received is in a second state given this same value of the bit received.

7. The method as claimed in any one of the preceding claims, **characterized in that** said integrity check coding is performed by a cyclic redundancy check coding.

8. The method as claimed in any one of claims 1 to 6, **characterized in that** said integrity check coding is performed by a hashing algorithm.

9. The method as claimed in any one of the preceding claims, **characterized in that** it is implemented by a radiofrequency transceiver device of a gateway system in a remote meter reading installation further comprising a plurality of metering devices, each metering device comprising a metering module and a radiofrequency module for transmitting data to said radiofrequency transceiver device of said gateway system.

10. A device for receiving digital data transmitted by frames using an integrity check coding, of the type comprising a decision unit (60) arranged so as to supply as output firm decisions concerning the value of each bit received of a series of bits of length N considered, the set of said firm decisions constituting a reference frame corresponding to an estimation of a frame received, and a checking unit (90) arranged to calculate a frame validation information item capable of supplying an indication of the compatibility of the frame received with said integrity check coding used, said device being **characterized in that** said decision unit (60) comprises:

   - means for calculating a value of likelihood of the value of the bit received representative of the probability of transmission error for each bit received of said reference frame,
   - means for storing a non-empty finite set of bits most likely errored of said reference frame as a function of said likelihood values calculated for each bit,
   - decision means arranged to list a plurality of candidate frames each corresponding respectively to one of the possible combinations of a number of inversions of the bits most likely errored, said checking unit (90) being designed to verify the compatibility of the candidate frames of said plurality of candidate frames listed with said integrity check coding, said decision means being arranged to select a candidate frame compatible with said integrity check coding in order to estimate the frame received, said decision unit being further suitable for receiving a first set of bits giving the length of the frame, considering at least two candidate frame length values determined as a function of the likelihood values calculated for each bit of said first set of bits, and in performing the estimation of the frame received through said means in ascending order of the frame lengths considered, in succession.

11. A gateway system for a remote meter reading installation, said gateway system comprising at least one radiofrequency transceiver device for communicating with a plurality of metering devices of said remote meter reading installation, said radiofrequency transceiver device comprising a reception device as claimed in claim 10.

12. A metering device for a remote meter reading installation of the type comprising a metering module and a radiofrequency module for communicating with a radiofrequency transceiver device of a gateway system of said remote meter reading installation, said radiofrequency module comprising a reception device as claimed in claim 10.

13. A remote meter reading installation, notably for water meters, comprising a plurality of metering devices as claimed in claim 12 and at least one gateway system as claimed in claim 11.

# Figure unique

EP 3 087 678 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6071823 A

- EP 1819058 A

**Littérature non-brevet citée dans la description**

- A Method of Improving Misframe for HEC-Based Variable Length Frame Suitable for IP Services. **UEDA H et al.** Electronics & Communications in Japan, Part 1. Wiley, Janvier 2003, vol. 86, 46-58